(19) Europäisches Patentamt
European Patent Office
Office européen des brevets

(11) **EP 2 286 473 B1**

(12) **FASCICULE DE BREVET EUROPEEN**

(45) Date de publication et mention de la délivrance du brevet:
**29.02.2012 Bulletin 2012/09**

(21) Numéro de dépôt: **09772700.2**

(22) Date de dépôt: **05.06.2009**

(51) Int Cl.:
*H01L 43/06* (2006.01)          *H01L 43/14* (2006.01)
*H01F 10/12* (2006.01)          *G11C 11/02* (2006.01)
*G01R 33/07* (2006.01)

(86) Numéro de dépôt international:
**PCT/FR2009/051062**

(87) Numéro de publication internationale:
**WO 2010/001018 (07.01.2010 Gazette 2010/01)**

(54) **ELEMENT MAGNETIQUE TRICOUCHES, PROCEDE POUR SA REALISATION, CAPTEUR DE CHAMP MAGNETIQUE, MEMOIRE MAGNETIQUE ET PORTE LOGIQUE MAGNETIQUE METTANT EN OEUVRE UN TEL ELEMENT**

DREISCHICHTIGES MAGNETISCHES ELEMENT, VERFAHREN ZU SEINER HERSTELLUNG, MAGNETFELDSENSOR, MAGNETISCHER SPEICHER UND MAGNETISCHES LOGIKGATTER MIT EINEM SOLCHEN ELEMENT

THREE-LAYER MAGNETIC ELEMENT, METHOD FOR THE PRODUCTION THEREOF, MAGNETIC FIELD SENSOR, MAGNETIC MEMORY, AND MAGNETIC LOGIC GATE USING SUCH AN ELEMENT

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **09.06.2008 FR 0853811**

(43) Date de publication de la demande:
**23.02.2011 Bulletin 2011/08**

(73) Titulaires:
• **Commissariat à l'Énergie Atomique et aux Énergies Alternatives**
  **75015 Paris (FR)**
• **Centre National de la Recherche Scientifique**
  **75016 Paris (FR)**

(72) Inventeurs:
• **RODMACQ, Bernard**
  **F-38113 Veurey Voroize (FR)**
• **AUFFRET, Stephane**
  **F-38410 Vaulnaveys Le Haut (FR)**
• **DIENY, Bernard**
  **F-38250 Lans En Vercors (FR)**
• **NISTOR, Lavinia Elena**
  **Hunedoara (RO)**

(74) Mandataire: **Vuillermoz, Bruno et al**
**Cabinet Laurent & Charras**
**"Le Contemporain"**
**50, Chemin de la Bruyère**
**69574 Dardilly Cédex (FR)**

(56) Documents cités:
**EP-A- 0 505 783**

• **RODMACQ B ET AL: "Crossovers from in-plane to perpendicular anisotropy in magnetic tunnel junctions as a function of the barrier degree of oxidation" JOURNAL OF APPLIED PHYSICS, AMERICAN INSTITUTE OF PHYSICS. NEW YORK, US, vol. 93, no. 10, 15 mai 2003 (2003-05-15), pages 7513-7515, XP012058203 ISSN: 0021-8979**
• **GARCIA F ET AL: "Exchange-biased spin valves with perpendicular magnetic anisotropy based on (Co/Pt) multilayers" JOURNAL OF APPLIED PHYSICS, AMERICAN INSTITUTE OF PHYSICS. NEW YORK, US, vol. 93, no. 10, 15 mai 2003 (2003-05-15), pages 8397-8399, XP012058489 ISSN: 0021-8979**

- **MORITZ J ET AL: "Extraordinary Hall effect in thin magnetic films and its potential for sensors, memories and magnetic logic applications; Potential of extraordinary Hall effect in thin magnetic films" JOURNAL OF PHYSICS D. APPLIED PHYSICS, IOP PUBLISHING, BRISTOL, GB, vol. 41, no. 13, 6 juin 2008 (2008-06-06), page 135001, XP020133425 ISSN: 0022-3727**

- **NAWRATH T ET AL: "MAGNETIC ANISOTROPIES AND MAGNETOTRASPORT IN CEH2/CO MULTILAYERS" PHYSICAL REVIEW, B. CONDENSED MATTER, AMERICAN INSTITUTE OF PHYSICS. NEW YORK, US, vol. 55, no. 5, PART 01, 1 février 1997 (1997-02-01), pages 3071-3082, XP000658410 ISSN: 0163-1829**

**Description**

**DOMAINE TECHNIQUE DE L'INVENTION**

La présente invention se rattache au domaine des matériaux magnétiques, plus particulièrement destinés à être mis en oeuvre en tant que capteurs de champ magnétique, ou au sein des mémoires magnétiques permettant le stockage et la lecture de données dans des systèmes électroniques, voire dans la réalisation d'éléments utilisables dans le domaine de la logique magnétique reprogrammable.

**ETAT ANTERIEUR DE LA TECHNIQUE**

Une des applications visées par la présente invention concerne des éléments magnétiques permettant la détection de champs magnétiques basée sur la mesure de l'Effet Hall Extraordinaire.

Il existe deux types d'Effets Hall: l'Effet Hall Ordinaire et l'Effet Hall Extraordinaire. L'Effet Hall Ordinaire existe dans les matériaux métalliques ou semi-conducteurs dopés, et est dû à la force de Lorentz agissant sur les électrons sous l'effet d'un champ magnétique. L'Effet Hall Extraordinaire existe limitativement dans les matériaux ferromagnétiques et résulte de la diffusion des électrons par interaction spin-orbite avec les moments magnétiques du matériau ferromagnétique.

Un paramètre caractéristique de l'Effet Hall est la résistivité de Hall, qui s'exprime selon l'expression :

$$\rho_{xy} = (V_{xy} / I)t = R_0 H + 4\pi R_s M_z \qquad (1)$$

où :

- $V_{xy}$ est la tension de Hall mesurée dans le plan du film mince suivant une direction perpendiculaire à celle du courant électrique,
- 1 est l'intensité du courant circulant dans le plan du film mince,
- t est l'épaisseur du film mince,
- $R_0$ est le coefficient de Hall Ordinaire,
- H est l'amplitude du champ magnétique appliqué,
- $R_s$ est le coefficient de Hall Extraordinaire et $M_z$ est la composante perpendiculaire de l'aimantation du film mince.

Le premier terme de l'équation (1), $R_0 H$, correspond à la résistivité de Hall Ordinaire, et le second terme, $4\pi R_s M_z$, correspond à la résistivité de Hall Extraordinaire. Pour des champs magnétiques relativement faibles, l'Effet Hall Ordinaire est généralement plusieurs ordres de grandeur plus faible que l'Effet Hall Extraordinaire, et peut donc être négligé.

Si l'aimantation du film ferromagnétique est parallèle au plan, ce qui est généralement le cas pour des couches minces, sa composante perpendiculaire $M_z$ augmente linéairement avec le champ magnétique appliqué hors du plan, jusqu'à atteindre l'aimantation à saturation $M_s$. Donc, tant que $M_z$ est inférieur à $M_s$, la tension de Hall Extraordinaire est proportionnelle au champ magnétique appliqué.

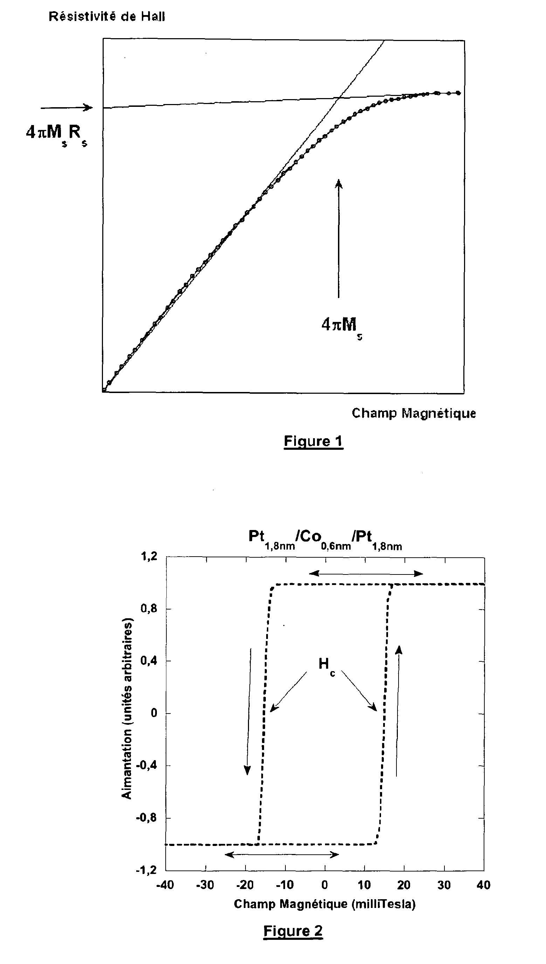

La figure 1 représente schématiquement la variation de la résistivité de Hall avec le champ magnétique appliqué, pour un matériau magnétique en couche mince dont l'aimantation est parallèle au plan. Pour $H < 4\pi M_s$, la résistivité varie linéairement avec le champ appliqué, jusqu'à atteindre $\rho_{xy} = 4\pi R_s M_s$. Au-delà, la résistivité varie linéairement avec le champ appliqué avec une pente $R_0$ (premier terme de l'équation (1)) beaucoup plus faible comme indiqué précédemment. La région utile de fonctionnement d'un capteur de champ magnétique basé sur ce principe est donc limitée à des valeurs de champ magnétique inférieures à $4\pi M_s$, où $M_s$ est l'aimantation à saturation du matériau magnétique considéré.

C'est la pente de la courbe $\rho_{xy}(H)$ qui détermine la sensibilité en champ magnétique d'un tel capteur, exprimée en micro-ohm centimètre par Tesla ($\mu\Omega$cm/T). Cette pente peut également, compte tenu de l'épaisseur t du film mince, et suivant la relation $\rho_{xy} = t \times R_{xy}$, être exprimée en ohm par Tesla ($\Omega$/T). Afin de maximiser cette pente, on peut, soit augmenter le terme $R_s$ d'Effet Hall Extraordinaire, soit diminuer l'anisotropie magnétique planaire du matériau afin de réduire le champ de saturation perpendiculaire.

Le choix d'un matériau à forte résistivité longitudinale et à forte diffusion spin-orbite est favorable pour maximiser $R_s$. Cette forte résistivité longitudinale est également un avantage car elle permet, pour des dispositifs de petite taille, de conserver une réponse en tension suffisante tout en limitant le courant circulant dans ledit dispositif à des valeurs supportables, au dessous d'une valeur entraînant des modifications structurales irréversibles (phénomènes d'électromigration).

La forte résistivité longitudinale est obtenue, soit en augmentant le désordre atomique du matériau (alliage désordonné par exemple), soit en diminuant l'épaisseur du film (il est connu que, pour une couche très mince, la résistivité électrique varie approximativement comme l'inverse de l'épaisseur du film). La contribution de diffusion spin-orbite est augmentée par un choix de matériau contenant des éléments de numéro atomique élevé, par exemple le platine, le palladium, l'or, ou les métaux de la série des Terres Rares.

Il faut néanmoins remarquer que l'incorporation de tels matériaux est forcément limitée en concentration afin de conserver de bonnes propriétés magnétiques à l'alliage ferromagnétique.

Le deuxième moyen d'augmenter la pente de la courbe $\rho_{xy}(H)$ est de diminuer l'anisotropie magnétique planaire du matériau, c'est-à-dire d'introduire un terme supplémentaire de signe opposé au terme classique $4\pi M_s$. Ce terme noté $H_s$ peut avoir pour origine soit une anisotropie volumique d'origine magnétocristalline ou induite par des contraintes élastiques de croissance, soit une anisotropie d'interface due à des interactions électroniques interfaciales. Un cas typique est par exemple l'influence d'une couche de platine au contact d'une couche magnétique de cobalt, de nickel ou de fer.

En présence de ce terme supplémentaire, le champ d'anisotropie perpendiculaire $H_K$ peut s'écrire de la façon suivante:

$$H_K = 4\pi M_s - H_S \qquad\qquad (2)$$

D'une manière qualitative, le champ d'anisotropie perpendiculaire $H_K$ va donc diminuer de façon régulière lorsque $H_s$ va augmenter, l'aimantation de la couche magnétique étant toujours parallèle au plan, jusqu'à tendre vers zéro, limite en deçà de laquelle, lorsque $H_s$ est supérieur à $4\pi M_s$, l'aimantation de la couche magnétique est spontanément (c'est à dire sans champ magnétique appliqué) perpendiculaire au plan de la couche. Dans ce dernier cas le matériau magnétique possède deux états stables en champ nul, et peut donc être intégré dans des dispositifs tels que mémoires magnétiques ou portes logiques magnétiques.

La figure 2 est une représentation schématique de la courbe d'aimantation obtenue dans cette situation, pour un échantillon typique de composition $Pt_{1,8nm}/CO_{0,6nm}/Pt_{1,8nm}$. Cette courbe peut être obtenue soit par mesure classique de magnétométrie, soit par mesure de l'Effet Hall, soit encore par mesure de l'Effet Kerr ou de l'Effet Faraday magnéto-optique.

Les flèches indiquent le sens de parcours du cycle magnétique lorsque l'on applique l'excitation magnétique H indiquée en abscisse. Les flèches monodirectionnelles représentent les évolutions irréversibles des cycles, tandis que les flèches bidirectionnelles représentent leurs évolutions réversibles. En ordonnée, les niveaux d'aimantation sont donnés en unités arbitraires.

En réduisant progressivement le champ magnétique appliqué d'une valeur positive, par exemple, à une valeur nulle, l'aimantation de la couche magnétique reste perpendiculaire à son plan et orientée dans le sens de ce champ magnétique précédemment appliqué. Il est alors nécessaire d'appliquer un champ magnétique de sens opposé, d'amplitude plus ou moins grande, afin de réorienter l'aimantation de la couche, toujours dans une direction perpendiculaire au plan, mais dans un sens opposé, à savoir dans le sens de ce nouveau champ magnétique appliqué.

Le champ magnétique nécessaire à ce basculement, plus précisément le champ magnétique qu'il faut appliquer pour que l'aimantation, moyennée sur l'ensemble des domaines magnétiques, soit nulle, est appelé champ coercitif, et dénommé $H_c$ sur la figure 2. La valeur de ce champ coercitif va déterminer la stabilité de l'aimantation, dans un sens ou dans l'autre, vis à vis des perturbations magnétiques extérieures.

Plus ce champ coercitif est fort, plus le matériau est stable vis à vis de ces perturbations. Mais aussi, dans ce cas, plus il est difficile de modifier intentionnellement la direction de l'aimantation par l'application d'un champ magnétique perpendiculaire, comme par exemple dans le cadre de l'utilisation de ce matériau en tant que mémoire magnétique, pour laquelle l'information est justement codée par le sens de l'aimantation.

On peut donc préférer un champ coercitif faible nécessitant moins d'énergie pour réussir à faire basculer l'aimantation, avec peut-être dans ce cas nécessité « d'isoler » magnétiquement le dispositif vis à vis des perturbations magnétiques extérieures, ou alors préférer un champ coercitif fort, ce qui rend le dispositif plus stable mais plus consommateur d'énergie dans la phase d'écriture de l'information.

Il faut également mentionner que l'on peut utiliser d'autres façons de déterminer l'orientation et l'amplitude de l'aimantation d'une couche magnétique, par exemple grâce aux effets magnéto-optiques, dans lesquels l'interaction entre la lumière incidente et les moments magnétiques de la couche magnétique provoque une rotation du plan de polarisation de la lumière incidente ainsi qu'une modification de son ellipticité.

Pour déterminer l'orientation de l'aimantation de cette couche magnétique, on peut également rajouter une deuxième couche magnétique, séparée de la première par une couche d'un métal non magnétique ou par une couche d'oxyde, la direction de l'aimantation de cette deuxième couche étant connue. En mesurant la résistance électrique d'une telle tricouche, on peut déterminer la direction de l'aimantation de la première couche magnétique, la résistance électrique de cet empilement étant plus faible dans le cas où les deux aimantations sont parallèles, comparé au cas où les aimantations sont anti-parallèles (phénomène bien connu de magnétorésistance géante ou tunnel). La circulation du courant électrique peut se faire, soit dans le plan des couches, soit dans une direction perpendiculaire au plan des couches si l'échantillon a été taillé sous la forme d'un pilier ayant des dimensions latérales de l'ordre du micron ou moins.

Pour déterminer l'orientation de l'aimantation de cette couche magnétique, on peut également placer à sa proximité une tête de lecture magnétorésistive qui sera influencée par le champ rayonné par les domaines magnétiques de cette couche.

Il existe dans la littérature quelques matériaux qui peuvent présenter certaines des caractéristiques exposées ci-dessus.

On peut citer par exemple les systèmes multicouches bien connus cobalt/platine, qui présentent une forte anisotropie magnétique perpendiculaire. En fonction des épaisseurs des couches élémentaires de platine et de cobalt, du nombre de répétitions du motif (Co/Pt) et de la présence d'une couche tampon de platine, on peut obtenir, soit un système présentant une aimantation spontanément (en champ magnétique nul) perpendiculaire au plan des couches, soit une aimantation dans le plan des couches mais présentant une très forte susceptibilité magnétique perpendiculaire (pente de la courbe $M_z = f(H)$). Malheureusement ces matériaux présentent une résistivité longitudinale faible, due à la faible résistivité de ses composants métalliques.

Des structures s'apparentant à celles de la présente invention ont également été étudiées (voir B. Rodmacq, S. Auffret. B. Dieny, S. Monso, P. Boyer, "Crossovers from in-plane to perpendicular anisotropy in magnetic tunnel junctions as a function of the barrier degree of oxidation", Journal of Applied Physics, 2003, Vol. 93, p 7513). Elles consistent en l'empilement, sur un substrat, de couches successives de platine, de cobalt, et d'oxyde d'aluminium, soit l'empilement inverse de l'un des empilements proposés dans la présente invention.

Dans ces structures, l'amplitude de l'Effet Hall est relativement faible, principalement du fait de la présence d'une couche de platine relativement épaisse dans laquelle est dérivée une partie non négligeable du courant électrique circulant dans la structure.

Des empilements de couches s'apparentant à ceux de la présente invention ont également été proposés dans la littérature, mais pas dans un but d'application dans des dispositifs de type capteurs de champ magnétique, mémoires magnétiques ou composants logiques magnétiques.

On peut en premier lieu citer des travaux concernant des multicouches composées de couches de cobalt alternant avec des couches d'alumine ($Al_2O_3$) (voir Ch. Morawe, H. Zabel, "Structure and thermal stability of sputtered metal/oxide multilayers: the case of Co/Al2O3", Journal of Applied Physics, 1995, Vol. 77, p. 1969). Dans cette publication, les auteurs ne mentionnent aucune éventuelle propriété d'anisotropie magnétique perpendiculaire de ces matériaux, objet de la présente invention.

De plus, ces auteurs ne destinent absolument pas, contrairement à la présente invention, ces matériaux à une utilisation dans le domaine des capteurs de champ magnétique ou des mémoires ou composants logiques magnétiques basés notamment sur la mesure de l'Effet Hall Extraordinaire. En effet, les auteurs proposent d'utiliser ces matériaux uniquement pour leurs propriétés structurales dans le cadre de miroirs pour les rayons X. Ces travaux ne relèvent donc pas du champ d'application visé par la présente invention.

On peut également citer des travaux concernant des multicouches "discontinues" composées de couches de cobalt ou d'alliages cobalt-fer alternant avec des couches de silice $SiO_2$ ou d'alumine $Al_2O_3$ (voir B. Dieny, S. Sankar, M. R. McCartney, D. J. Smith, P. Bayle-Guillemaud, A. E. Berkowitz, "Spin-dependent tunnelling in discontinuous metal/insulator multilayers", Journal of Magnetism and Magnetic Materials, 1998, Vol.185, p.283). Par le terme « discontinues », les auteurs font référence au fait que les couches de cobalt ou d'alliage cobalt-fer ne sont pas sous forme de couche mince d'épaisseur quasi-uniforme, mais plutôt sous la forme d'agrégats de cobalt ou cobalt-fer enrobés dans la matrice d'oxyde.

Ces systèmes sont préparés par pulvérisation cathodique en déposant alternativement les couches de métal magnétique et les couches d'oxydes. Or, les atomes de cobalt ou de cobalt-fer tendent à coalescer sous la forme d'îlots disjoints, ce qui conduit à une structure en plan d'agrégats plus ou moins indépendants, suivant l'épaisseur de métal déposée, noyés dans la matrice isolante.

Dans ces structures, on ne conserve donc que le « souvenir » de cette couche mince de cobalt ou cobalt-fer, ce qui est une situation complètement différente de celle considérée dans la présente invention. Dans ces études relatives aux multicouches discontinues métal/isolant, aucune mention n'est faite quant à d'éventuelles propriétés d'anisotropie magnétique perpendiculaire de ces matériaux. Enfin, ces auteurs ne destinent pas non plus ces matériaux à une utilisation dans le domaine des capteurs de champ magnétique ou des mémoires ou composants logiques magnétiques basés notamment sur la mesure de l'Effet Hall Extraordinaire. Ces travaux ne relèvent donc pas non plus du champ d'application visé par la présente invention.

On peut aussi citer des travaux concernant des multicouches fabriquées par dépôt d'un alliage cobalt-fer suivi d'une oxydation naturelle de la surface de cet alliage en présence d'oxygène (voir G. S. D. Beach, A. E. Berkowitz, "Co-Fe metallnative-oxide multilayers: a new direction in soft magnetic thin film design 1. Quasi-static properties and dynamic response", IEEE Transactions on Magnetics, 2005, Vol. 41, p 2043, et G. S. D. Beach, A. E. Berkowitz, "Co-Fe metal/native-oxide multilayers: a new direction in soft magnetic thin film design II. Microscopic characteristics and interactions", IEEE Transactions on Magnetics, 2005, Vol. 41, p 2053).

Ces multicouches présentent une forte résistivité électrique, un fort moment magnétique et une grande « douceur » magnétique (facilité à saturer l'aimantation dans une direction parallèle au plan des couches). Les auteurs ne mentionnent pas de propriété spéciale quant à l'amplitude de l'Effet Hall Extraordinaire.

S'ils présentent des résultats semblant indiquer une tendance à l'apparition d'une certaine anisotropie perpendiculaire pour les faibles épaisseurs de métal magnétique, un examen plus précis des résultats montre que la réduction observée de l'amplitude du champ d'anisotropie perpendiculaire $H_K$ est essentiellement due à une diminution du terme $4\pi M_s$ (voir relation (2)), et non à une quelconque contribution d'un terme d'anisotropie perpendiculaire $H_s$.

De la même manière, les auteurs prédisent que l'aimantation est spontanément perpendiculaire au plan des couches pour des épaisseurs de métal magnétique inférieures à 1,1 nanomètre, alors que dans le même temps ils présentent des résultats pour une épaisseur de 1,0 nanomètre, donc inférieure à cette limite, qui montrent sans ambiguïté que l'aimantation est dans ce cas parallèle au plan des couches et non pas perpendiculaire.

On peut enfin citer des travaux concernant des empilements constitués de deux multicouches (Pt/Co) et (Co/Pt) séparées par une couche d'oxyde NiO (voir C. Christides et Th. Speliotis, "Polarity of anomalous Hall effect hysteresis loops in (Pt/Co)15/AF/(Co/Pt)15 (AF= FeMn, NiO) multilayers with perpendicular anisotropy", Journal of Applied Physics, 2005, Vol. 97, p. 013901).

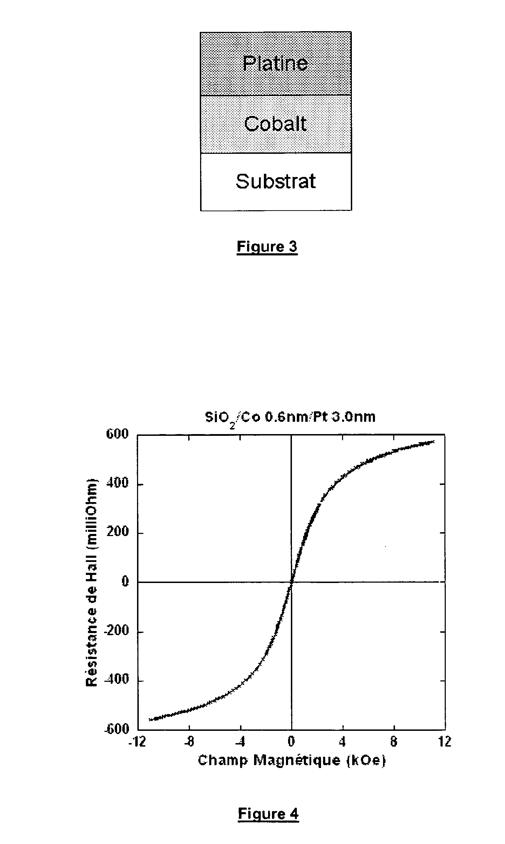

Dans ce document, il apparaît que les deux multicouches de part et d'autre de la couche de NiO auraient leur aimantation perpendiculaire au plan des couches en l'absence de la couche d'oxyde NiO. Ceci ressort clairement de la comparaison de la figure 2 (présence de la couche de NiO) et de la figure 3 (absence de la couche de NiO) page 013901-3, figures qui montrent que dans les deux cas l'aimantation des couches magnétiques est orientée perpendiculairement au plan des couches. Contrairement à la présente invention, ce n'est donc pas la présence de la couche séparatrice de NiO qui confère à cet empilement ses propriétés d'anisotropie magnétique perpendiculaire.

Il résulte de ces considérations qu'aucun des matériaux magnétiques connus actuellement ne rassemble toutes les propriétés nécessaires à son utilisation en tant que capteur de champ magnétique, à savoir une forte résistivité longitudinale (au moins quelques centaines de $\mu\Omega cm$), une forte résistivité de Hall (quelques pour cent de la résistivité longitudinale) et une forte susceptibilité magnétique perpendiculaire (au moins dix fois plus forte que pour un matériau magnétique classique à aimantation planaire, c'est-à-dire avec un champ de saturation hors du plan au plus de l'ordre de quelques dizaines de milliteslas), voire même une aimantation perpendiculaire en champ nul pour les applications de type mémoires magnétiques ou portes logiques magnétiques.

Par ailleurs, pour les applications de type mémoires magnétiques ou portes logiques magnétiques, les matériaux connus du type (Pt/Co) ou alliages Terre Rare/métaux de transition ne présentent pas l'ensemble des propriétés requises pour ce type d'applications (forte polarisation en spin des électrons (si la magnétorésistance est utilisée pour détecter le signal), bonne stabilité thermique lors des recuits, faible corrosion).

## EXPOSE DE L'INVENTION

La présente invention propose un moyen de réalisation d'un élément magnétique en tricouches non magnétique / magnétique / non magnétique, dont l'aimantation de la couche magnétique est parallèle au plan des couches en l'absence des deux couches non magnétiques, et qui présente un champ d'anisotropie hors du plan d'une valeur proche de ou supérieure à son champ démagnétisant, de sorte que l'élément magnétique possède, soit une grande sensibilité au champ magnétique, laquelle peut être détectée par la mesure de l'Effet Hall Extraordinaire, ou encore par la mesure de la magnétorésistance ou de l'Effet Kerr ou de l'Effet Faraday magnéto-optiques, soit une aimantation spontanément perpendiculaire au plan des couches en l'absence de champ magnétique appliqué.

Le matériau utilisé permet de réunir les avantages des différents matériaux cités ci-dessus, à savoir une forte anisotropie perpendiculaire pouvant compenser ou même surpasser l'anisotropie de forme propre aux couches minces, et dans le cas particulier de la mesure de l'Effet Hall, une forte résistivité longitudinale et un fort coefficient de Hall extraordinaire.

Ainsi, l'invention vise un élément magnétique tricouches, comportant, sur un substrat, une couche d'oxyde, d'hydrure ou de nitrure O, surmontée d'une couche métallique magnétique M, surmontée elle-même, soit d'une deuxième couche d'oxyde, d'hydrure ou de nitrure O', soit d'une couche métallique non ferromagnétique M', réalisant ainsi des structures génériques du type O/A4/O ou O/M/M', et dans lequel les couches M sont continues.

La forte anisotropie magnétique perpendiculaire évoquée plus haut est obtenue, comme dans le cas des multicouches cobalt/platine, par des effets de contrainte et d'hybridation électronique aux interfaces entre la couche magnétique et la ou les couches d'oxyde, d'hydrure ou de nitrure. Comme dans le système (Co/Pt), la couche magnétique doit donc être mince (quelques nanomètres) afin que ces effets d'interfaces ne deviennent pas négligeables devant l'anisotropie magnétique volumique de forme, qui elle tend à maintenir l'aimantation de la couche magnétique dans le plan.

La forte résistivité longitudinale est obtenue par l'utilisation de couches magnétiques minces, donc de forte résistivité du fait du rôle important joué par les diffusions interfaciales, au contact avec une ou des couches d'oxyde, de nitrure ou d'hydrure. La résistance électrique de l'ensemble de l'empilement est donc élevée.

Selon l'invention, la couche métallique magnétique M présente une épaisseur comprise entre 1 et 5 nanomètres et est constituée d'un matériau magnétique, d'un alliage magnétique ou d'une multicouche formée de l'alternance de matériaux non magnétiques et magnétiques, ces derniers étant choisis dans le groupe constitué par Fe, Ni, Co ou leurs alliages.

Par ailleurs, la ou les couches O et O' d'oxyde, d'hydrure ou de nitrure présentent une épaisseur au moins égale à 0,3 nanomètre et sont réalisées à base d'éléments choisis dans le groupe comprenant Al, Mg, Ru, Ta, Cr, Zr. Hf, Ti, V, Si, Cu, W, Co, Ni, Fe, ou leurs alliages, et plus généralement de tout matériau ou alliage susceptible de former des oxydes, hydrures ou nitrures stables.

Avantageusement, le substrat recevant l'empilement précité est réalisé en silicium recouvert de silicium oxydé ou nitruré thermiquement ou naturellement sur une épaisseur comprise entre 2 et 500 nanomètres.

Cependant, ledit substrat peut être réalisé en un matériau transparent tel que par exemple du verre ou de l'oxyde de magnésium.

Selon une autre caractéristique avantageuse de l'invention, la couche métallique magnétique M contient des additions de métaux non magnétiques Pd ou Pt, servant à modifier les propriétés d'anisotropie magnétique perpendiculaire de cette couche, ou d'éléments choisis dans le groupe comprenant Si, C, B, P, N, servant à modifier la résistivité électrique de cette couche et/ou son aimantation par unité de volume.

Selon l'invention, la ou les couches O et O' sont réalisées en un même matériau non magnétique. Cependant, la composition chimique de l'une des couches O peut être différente de l'autre. En outre, les deux couches O et O' peuvent présenter ou non la même épaisseur.

Selon l'invention, au moins l'une des couches O ou O' peut elle-même être constituée d'une pluralité de couches réalisées en oxyde, en hydrure ou en nitrure.

Avantageusement :

- la couche métallique magnétique M présente une épaisseur comprise entre 1 et 5 nanomètres,
- la ou les couches O ou O' présentent une épaisseur comprise entre 0,3 et 5 nanomètres.
- la couche non ferromagnétique M' présente une épaisseur comprise entre 0,3 et 20 nanomètres,

L'élément magnétique de l'invention présente avantageusement des dimensions latérales inférieures à 1 micromètre.

L'invention concerne également un procédé de réalisation de l'élément magnétique en question. Ce procédé consiste :

- à déposer, sur une surface électriquement isolante, une première couche du métal constitutif de la couche O par pulvérisation cathodique,
- à oxyder, hydrurer ou nitrurer cette première couche O,
- à déposer sur cette première couche O, ou directement sur le substrat, une couche métallique magnétique M par pulvérisation cathodique,
- à déposer par pulvérisation cathodique sur cette couche métallique magnétique M, soit une deuxième couche d'un métal constitutif de la couche O', subséquemment oxydée, nitrurée ou hydrurée, soit une couche métallique M',
- à établir des contacts électriques avec la couche M lorsque l'on désire mesurer les propriétés de l'élément magnétique par circulation d'un courant électrique et mesure d'une tension.

Alternativement, les première et deuxième étapes peuvent n'en constituer qu'une seule, à savoir le dépôt direct, par pulvérisation radio-fréquence par exemple, de la couche d'oxyde, d'hydrure ou de nitrure à partir d'une cible composée de l'oxyde, de l'hydrure ou du nitrure correspondant.

Selon le procédé de l'invention, l'élément magnétique est taillé sous forme d'un pilier à base carrée, rectangulaire, circulaire ou elliptique, avec des dimensions latérales de quelques centaines de nanomètres ou moins. Il peut également être taillé, toujours pour la même gamme de dimensions, sous une forme permettant la détection du signal magnétique par mesure de l'Effet Hall Extraordinaire.

Selon une variante de l'invention, la ou les couches O ou O' sont obtenues par oxydation, hydruration ou nitruration naturelle d'une couche métallique.

Selon une autre variante, la ou les couches O ou O' sont obtenues par oxydation, hydruration ou nitruration par procédé plasma d'une couche métallique.

Selon encore une autre variante de l'invention, la ou les couches O ou O' sont obtenues par pulvérisation réactive d'une couche métallique en présence d'oxygène, d'hydrogène ou d'azote dans l'atmosphère de la chambre de dépôt.

Selon encore une autre variante de l'invention, la ou les couches O ou O' sont obtenues par dépôt direct de l'oxyde, de l'hydrure ou du nitrure par pulvérisation cathodique radio-fréquence à partir d'un matériau-cible composite d'oxyde, d'hydrure ou de nitrure métallique.

Selon encore une autre variante de l'invention, c'est le substrat lui-même, composé ou recouvert d'un oxyde, nitrure ou hydrure, qui joue le rôle de la couche O.

Selon l'invention, le dépôt de certaines couches est réalisé à une température différente de la température ambiante. Par exemple, la ou les couches d'oxyde, d'hydrure ou de nitrure peuvent avoir une meilleure qualité structurale si on les fait croître à température élevée (par exemple 200°C). Par ailleurs, le dépôt d'une couche peut en outre être suivi d'un traitement thermique à une température supérieure à ladite température de dépôt. Cela peut être le cas par exemple pour favoriser l'oxydation ou la nitruration d'une couche ou encore permettre la cristallisation d'une couche amorphe.

Par ailleurs, après réalisation des étapes de dépôt, on peut soumettre l'ensemble ainsi obtenu à un traitement thermique pendant un temps plus ou moins long, dans une atmosphère raréfiée, ou en présence d'un certain gaz ou mélange de différents gaz, tels que l'oxygène, l'hydrogène ou l'azote par exemple, afin de modifier la structure et/ou les propriétés de transport électrique et/ou les propriétés magnétiques de l'élément magnétique.

Les étapes de dépôt des différentes couches, ou le traitement thermique d'une partie ou de l'ensemble des couches constituant l'empilement, peuvent être réalisés en présence d'un champ magnétique extérieur apte à modifier les caractéristiques magnétiques de l'ensemble de l'empilement.

L'invention vise un capteur de champ magnétique constitué de l'élément magnétique tricouches de l'invention, ce dernier présentant un champ d'anisotropie perpendiculaire contrebalançant presque son champ démagnétisant.

L'invention vise également une mémoire magnétique constituée de l'élément magnétique tricouches en question, dans lequel l'aimantation de la couche magnétique est orientée perpendiculairement au plan des couches en l'absence de champ magnétique extérieur.

L'invention concerne également une porte logique magnétique constituée dudit élément magnétique tricouches, dans lequel la direction de l'aimantation de la couche magnétique est perpendiculaire au plan des couches en l'absence de champ magnétique extérieur. L'invention peut être également utilisée de façon générale dans les dispositifs à déplacement de parois magnétiques tels que les registres à décalage proposés par exemple dans le document US 6 920 062. Dans ces dispositifs, l'information est stockée sous la forme d'une succession de domaines dont les aimantations sont orientées « vers le haut » ou « vers le bas ». Chaque domaine représente un bit d'information. Ils sont séparés par des parois magnétiques. Les parois magnétiques et donc les domaines, peuvent être avantageusement déplacées dans ces structures par circulation d'un courant électrique qui exerce une force sur les parois par l'effet de transfert de spin. Un capteur magnétorésistif ou à effet Hall placé à un endroit donné à proximité ou sur le dispositif permet de détecter le passage des parois et des domaines et remonter ainsi à l'information magnétique écrite dans le dispositif.

Afin de déterminer l'orientation de l'aimantation de la couche magnétique de l'élément magnétique :

- on mesure l'Effet Hall Extraordinaire par circulation d'un courant électrique dans une direction parallèle au plan des couches,
- ou on mesure la magnétorésistance par circulation d'un courant électrique dans une direction perpendiculaire ou parallèle au plan des couches,
- ou on mesure l'Effet Kerr ou l'Effet Faraday magnéto-optique,
- ou encore on utilise le champ rayonné par les domaines magnétiques pour influencer une tête de lecture magnétorésistive située à proximité de l'élément magnétique.

**BREVE DESCRIPTION DES DESSINS**

La figure 1 est une représentation schématique d'une courbe d'aimantation caractéristique d'un élément magnétique de l'art antérieur.

La figure 2 est une représentation schématique de la variation typique de l'aimantation en fonction du champ magnétique pour un matériau à anisotropie magnétique perpendiculaire.

Ces deux premières figures ont déjà été décrites en relation avec l'état antérieur de la technique.

La figure 3 est une représentation schématique d'une première forme de réalisation de l'élément magnétique conforme à l'invention.

La figure 4 représente la variation de la résistance de Hall en fonction du champ magnétique perpendiculaire pour une structure du type $SiO_2$ / Co 0.6nm / Pt 3.0nm.

La figure 5 représente la variation de la résistance de Hall en fonction du champ magnétique perpendiculaire pour une structure du type SiO$_2$ / Co 1.5m / Pt 3.Onm.

La figure 6 est une représentation schématique d'une deuxième forme de réalisation de l'élément magnétique conforme à l'invention.

La figure 7 représente la variation de la résistance de Hall en fonction du champ magnétique perpendiculaire pour une structure du type SiO$_2$ / AlOx 2.0nm / Co 1.5nm / Pt 3.0nm. Un plasma d'oxygène a été utilisé pour oxyder la couche d'aluminium.

La figure 8 est une représentation schématique d'une troisième forme de réalisation de l'élément magnétique conforme à l'invention.

La figure 9 est une représentation schématique d'une quatrième forme de réalisation de l'élément magnétique conforme à l'invention.

La figure 10 est une représentation schématique d'une cinquième forme de réalisation de l'élément magnétique conforme à l'invention.

La figure 11 est une représentation schématique d'une sixième forme de réalisation de l'élément magnétique conforme à l'invention.

La figure 12 représente la variation de la résistance de Hall en fonction du champ magnétique perpendiculaire pour une structure du type SiO$_2$ / Co 1.5nm / Pt 3.0nm pour différentes températures de recuit.

La figure 13 représente la variation de la résistance de Hall en fonction du champ magnétique perpendiculaire pour une structure du type SiO$_2$ / AlOx 0.6nm / Co 1.5m / Pt 3.0nm pour différentes températures de recuit. Une oxydation naturelle a été utilisée pour oxyder la couche d'aluminium.

La figure 14 représente la variation de la résistance de Hall en fonction du champ magnétique perpendiculaire pour une structure du type SiO$_2$ / AlOx 2.0nm / Co 1.5m / Pt 3.0 nm pour différentes températures de recuit. Un plasma d'oxygène a été utilisé pour oxyder la couche d'aluminium

La figure 15 représente la variation de la résistance de Hall en fonction du champ magnétique perpendiculaire pour une structure du type SiO$_2$ / MgOx 1.4nm / Co 1.5m / Pt 3.0nm pour différentes températures de recuit. Une oxydation naturelle a été utilisée pour oxyder la couche de magnésium.

## DESCRIPTION DES MODES PARTICULIERS DE REALISATION DE L'INVENTION

Sans être limitatif, et à titre d'exemple, les matériaux et les techniques utilisés dans les modes de réalisation décrits ci après sont les suivants.

La figure 3 est une représentation schématique d'une première forme de réalisation conforme à l'invention. Sur un substrat possédant les caractéristiques requises pour remplacer la couche O, et recouvert par exemple de silicium oxydé ou nitruré, ou composé par exemple de verre ou d'oxyde de magnésium, on dépose une couche magnétique M, en l'espèce du cobalt, dont l'épaisseur est généralement faible. Si cette épaisseur dépasse une certaine valeur dépendant du matériau utilisé pour la couche M et de l'intensité des interactions interfaciales avec les matériaux au contact de cette couche magnétique M, l'aimantation n'est pas, de manière connue, perpendiculaire au plan de la couche du fait de l'anisotropie volumique de forme de cette couche M qui tend à maintenir l'aimantation de cette couche dans son plan.

Pour cette couche M, le choix de son épaisseur est surtout déterminé par la possibilité d'obtention d'une couche métallique continue. En effet, comme discuté précédemment, certains métaux magnétiques mouillent mal sur les oxydes tels que la silice ou l'alumine. Dans certains cas, le métal magnétique a tendance à coalescer sous la forme d'îlots plus ou moins disjoints suivant l'épaisseur du métal déposée.

Sur cette couche magnétique M, on peut ensuite avantageusement déposer une couche d'un métal non ferromagnétique M', par exemple du platine, afin soit de protéger l'ensemble de la structure ainsi réalisée contre une oxydation naturelle ultérieure, soit de faciliter le passage d'un courant électrique.

La figure 4 est une illustration de cette forme de réalisation. L'empilement comprend, sur un substrat de silicium oxydé, une couche magnétique de cobalt de 0,6 nanomètre d'épaisseur, surmontée d'une couche de platine de 3 nanomètres d'épaisseur. On mesure la variation de la résistance de Hall en fonction du champ magnétique extérieur appliqué perpendiculairement au plan des couches.

Cette figure 4 montre une augmentation régulière et non linéaire de la résistance de Hall avec le champ magnétique, contrairement par exemple au cas illustré sur la figure 1, où il était aisé de distinguer les deux contributions linéaires à cette résistance, la première proportionnelle à l'aimantation (contribution extraordinaire), et la deuxième, pour des champs appliqués plus forts, proportionnelle à ce champ appliqué (contribution ordinaire). Ceci signifie que, dans le cas exposé sur la figure 4. il n'est pas possible d'aligner parfaitement l'aimantation de la couche de cobalt dans une direction parallèle au champ magnétique, même pour des champs de forte intensité. Ceci est une caractéristique des matériaux dits « superparamagnétiques », pour lesquels les petits îlots de cobalt ne sont pas suffisamment stables magnétiquement vis à vis de l'agitation thermique.

Dans d'autres cas, les effets de tension superficielle sont trop faibles pour que le phénomène de coalescence en îlots ait lieu. La couche métallique peut alors être continue. La gamme d'épaisseurs permettant l'obtention de couche continue de métal dépend de l'énergie surfacique de l'oxyde, de l'énergie surfacique du métal et de l'énergie interfaciale de l'interface oxyde/métal, et de la mouillabilité de la surface de dépôt par la couche métallique d'apport. Cette gamme d'épaisseur possible pour l'obtention de couches métalliques continues dépend donc à la fois du métal M et de l'oxyde.

Dans d'autres cas encore, augmenter légèrement l'épaisseur de la couche magnétique permet d'augmenter le taux de recouvrement de la surface jusqu'à un point où les îlots mentionnés ci-dessus vont entrer en contact les uns avec les autres, permettant ainsi de recouvrer de bonnes propriétés magnétiques.

Pour un même matériau de base M, on peut modifier l'épaisseur de la couche magnétique pour laquelle ou recouvre de bonnes propriétés magnétiques en ajoutant à ce matériau magnétique des éléments pouvant améliorer la mouillabilité sur le substrat en abaissant l'énergie de surface du métal à la faveur de l'énergie de l'interface oxyde/métal. Selon un mode habituel de réalisation, le matériau est un métal magnétique, comme le cobalt, d'épaisseur comprise entre 1 et 5 nanomètres, typiquement de 1,5 nanomètre.

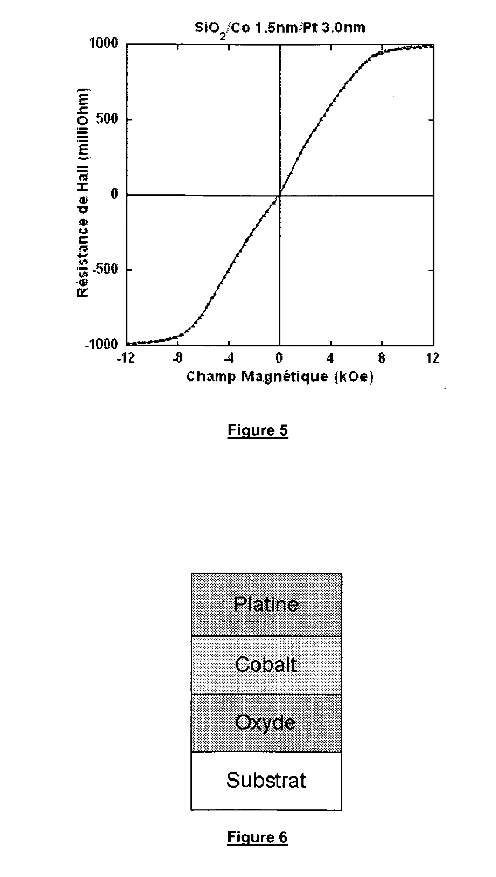

C'est ce cas qui est illustré en relation avec la figure 5, qui montre la variation de la résistance de Hall en fonction du champ magnétique extérieur, appliqué perpendiculairement au plan des couches, pour un empilement du type (substrat / Co 1,5 nm / Pt 3 nm). Dans ce cas, on retrouve une variation de la résistance de Hall conforme à celle de la figure 1, l'aimantation de la couche de cobalt pouvant être alignée dans la direction d'un champ magnétique extérieur d'une intensité d'environ 8 kOe.

Compte tenu de la relation (2), on constate dans ce cas la présence d'une contribution non négligeable d'anisotropie perpendiculaire $H_s = 4\pi M_s - H_K = 18-8 = 10$ kOe, relation dans laquelle on a pris l'aimantation de la couche de cobalt égale à 1430 uem/cm$^3$.

Afin d'adapter les propriétés magnétiques du dispositif en fonction de l'application visée (capteur de champ, dispositif mémoire ou porte logique) et obtenir les meilleures performances notamment en terme d'anisotropie magnétique perpendiculaire, la couche de cobalt peut être remplacée par un alliage $C_{O_x}Fe_{l-}x$ de concentration variable, ou par un alliage ternaire $Co_xNi_yFe_{100-x-y}$, ou par un alliage, cristallisé ou amorphe, d'un ou plusieurs de ces matériaux magnétiques avec un autre élément non magnétique, tel le bore, le silicium, le phosphore, et/ou le carbone. On peut également utiliser un alliage ou une multicouche composée d'un matériau magnétique et d'un matériau non magnétique.

La figure 6 est une représentation schématique d'une deuxième forme de réalisation conforme à l'invention.

Sur le substrat précédemment mentionné, on dépose la couche O, préférentiellement en oxyde d'aluminium, dont l'épaisseur est de l'ordre de 0,3 à 5 nanomètres, ce dernier chiffre n'étant pas très critique. Cette couche est généralement constituée d'un dépôt de métal, comme par exemple l'aluminium, qui a été oxydé. Mais l'aluminium peut être remplacé par tout autre élément susceptible de former avec l'oxygène des oxydes en couches minces de bonne qualité, à savoir par exemple le magnésium, le ruthénium, le silicium, le tantale, le chrome, le zirconium, le titane, l'hafnium, le vanadium, le cobalt, le nickel, le fer, le cuivre, le tungstène, et plus généralement de tout matériau ou alliage susceptible de former des oxydes stables. On peut également utiliser pour certaines réalisations particulières, un alliage ou une multicouche de ces matériaux en tant que couche d'oxyde élémentaire.

Il est également possible de réaliser l'oxyde, non pas par une technique d'oxydation plasma, mais par une technique connue de pulvérisation réactive de l'élément considéré en présence d'une certaine quantité d'oxygène dans l'atmosphère de la chambre de dépôt, ou par une technique d'oxydation naturelle, ou encore en déposant directement l'oxyde par pulvérisation radio-fréquence d'un matériau-cible composite MOx, où M désigne un des métaux cités plus haut et Ox l'oxygène.

Des résultats analogues peuvent être obtenus en effectuant une nitruration ou une hydruration et non pas une oxydation.

Sur cette première couche d'oxyde, hydrure ou nitrure O, on dépose ensuite la couche magnétique M, par exemple du cobalt, puis éventuellement une dernière couche métallique non ferromagnétique M', par exemple du platine, ainsi qu'indiqué dans la première forme de réalisation de l'invention en relation avec la figure 3.

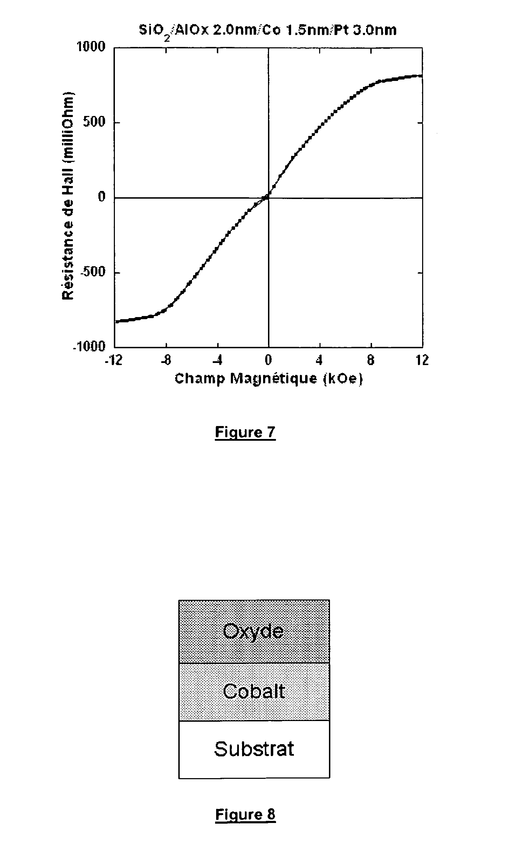

C'est cette deuxième forme de réalisation qui est illustrée en relation avec la figure 7. L'empilement comprend, sur un substrat de silicium oxydé, une couche d'aluminium de 0,6 nanomètre d'épaisseur, exposée après dépôt à une atmosphère d'oxygène, puis une couche de cobalt de 1,5 nanomètre d'épaisseur, surmontée d'une couche de platine de 3 nanomètres d'épaisseur. On mesure la variation de la résistance de Hall en fonction du champ magnétique extérieur appliqué perpendiculairement au plan des couches.

Comme dans le cas de la figure 5, on retrouve une variation de la résistance de Hall conforme à celle de la figure 1, l'aimantation de la couche de cobalt pouvant être alignée dans la direction d'un champ magnétique extérieur d'une intensité d'environ 8 kOe. On constate donc également la présence d'une contribution non négligeable d'anisotropie perpendiculaire.

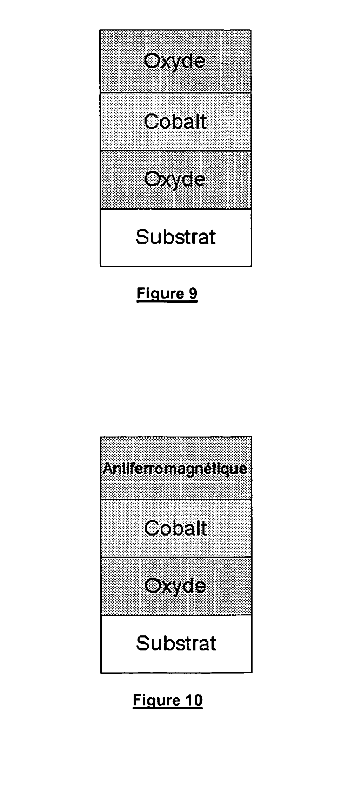

Les figures 8 et 9 sont des représentations schématiques d'une troisième et quatrième formes de réalisation conforme à l'invention.

Dans ce cas, on a remplacé la couche métallique non ferromagnétique supérieure M' utilisée dans les première et deuxième formes de réalisation par une couche d'oxyde O'. L'intérêt principal de ces formes de réalisation est que le courant électrique éventuellement injecté dans une direction parallèle au plan des couches circule uniquement dans la couche magnétique. Ceci entraîne donc une bien meilleure efficacité du dispositif si par exemple ce courant électrique est utilisé à des fins de mesure de la tension de Hall, ou si ce courant électrique est utilisé à des fins de manipulation de l'état magnétique du dispositif, pour par exemple déplacer des parois de domaines magnétiques comme dans le document US 6 920 062.

Pour ces deux dernières formes de réalisation, la nature, la composition chimique, l'épaisseur ou le mode de fabrication de la deuxième couche d'oxyde ne doivent pas être forcément identiques à ceux du substrat ou de la première couche d'oxyde.

Dans une cinquième forme de réalisation, comme illustré schématiquement sur la figure 10, il est possible de mettre au contact de la couche M considérée, en l'espèce en cobalt, une couche d'un matériau M' antiferromagnétique, tel les alliages IrMn, PtMn, FeMn ou NiMn, réputés pour induire un couplage d'anisotropie d'échange avec ladite couche M.

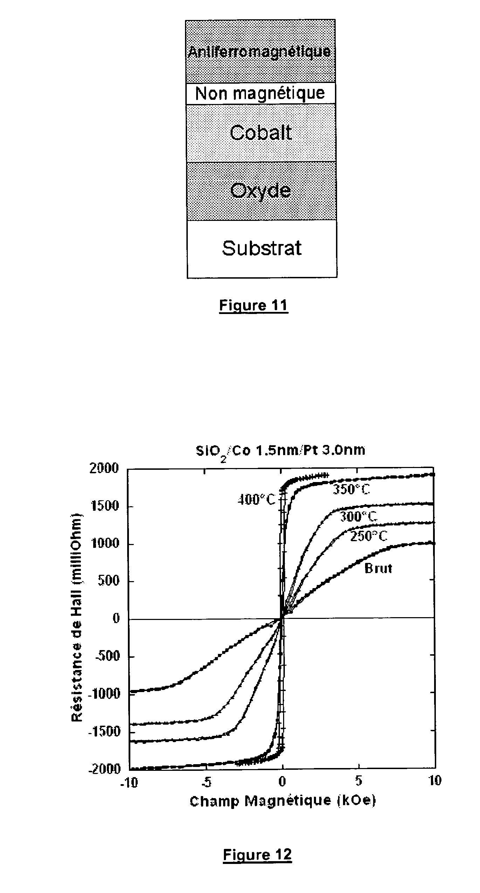

Dans une sixième forme de réalisation, comme illustré schématiquement sur la figure 11, il est également possible d'insérer une couche métallique non magnétique, par exemple du platine, d'une épaisseur comprise entre 0,1 et 1 nanomètre entre ladite couche M et ledit matériau réputé pour induire un couplage d'échange avec ladite couche M.

Pour l'une des quelconques formes de réalisation décrites ci-dessus, il est possible de déposer les couches successives, ou certaines d'entre elles, sur un substrat maintenu à une température différente de la température ambiante. Il peut aussi être intéressant d'effectuer ces dépôts en présence d'un champ magnétique extérieur.

Par ailleurs, après réalisation des étapes de dépôt, on peut soumettre l'ensemble ainsi obtenu à un traitement thermique pendant un temps plus ou moins long, dans une atmosphère raréfiée, ou en présence d'un certain gaz ou mélange de différents gaz, tels que l'oxygène, l'hydrogène ou l'azote par exemple, en présence ou en l'absence d'un champ magnétique extérieur, afin de modifier la structure et/ou les propriétés de transport électrique et/ou les propriétés magnétiques du dispositif.

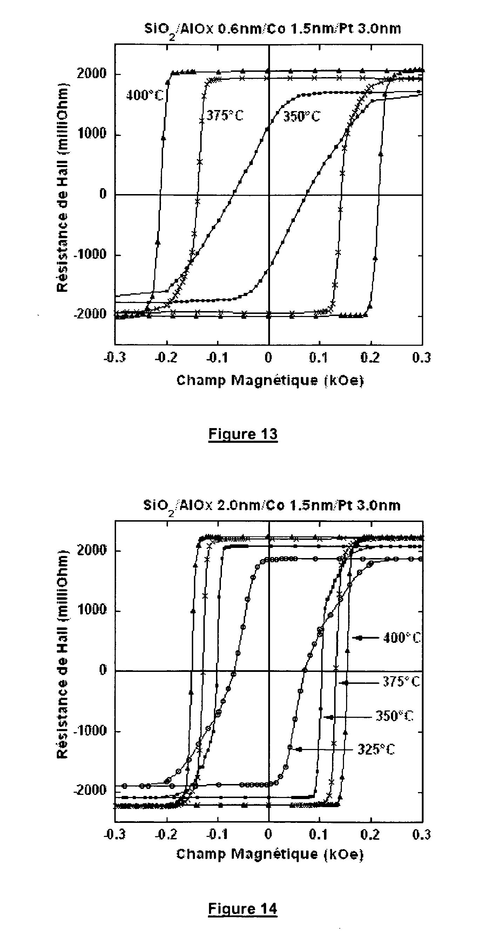

C'est l'effet de ces traitements thermiques post-dépôt qui est illustré sur la figure 12, utilisant la première forme de réalisation, et sur les figures 13, 14 et 15, utilisant la deuxième forme de réalisation. Dans ces cas, les empilement représentés schématiquement aux figures 3 et 6 ont été, après dépôt, maintenus à une température comprise entre 20°C et 400°C pendant un temps de 30 minutes dans une atmosphère raréfiée de $10^{-6}$ mbar, puis refroidis jusqu'à la température ambiante, où leurs propriétés magnétiques ont à nouveau été mesurées.

La figure 12 correspond à un empilement du type substrat / M / M' (première forme de réalisation), dans lequel le substrat consiste en silicium recouvert de 500 nanomètres d'oxyde de silicium, M représente une couche de cobalt d'une épaisseur de 1,5 nanomètre, recouverte d'une couche M' de platine de 3 nanomètres d'épaisseur.

Tout d'abord, on constate sur cette figure une importante augmentation de l'amplitude de la résistance de Hall suite aux différents traitements thermiques. Cette amplitude en effet augmente d'un facteur deux après traitement thermique à une température de 400°C par rapport à l'amplitude mesurée juste après dépôt de l'empilement.

De plus, le champ de saturation perpendiculaire $H_K$ (voir relation (2)) diminue progressivement lorsque la température de recuit augmente, jusqu'à devenir négatif (l'aimantation de la couche de cobalt est alors spontanément perpendiculaire au plan des couches) après traitement thermique à 400°C. Pour des températures de recuit intermédiaires, la pente de la courbe R(H) peut atteindre des valeurs très importantes, permettant à cet empilement d'être utilisé en tant que capteur de champ magnétique.

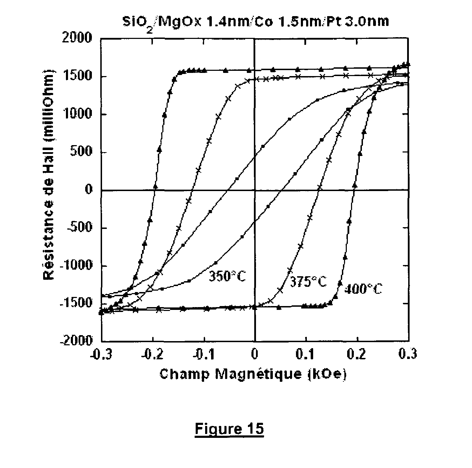

Les figures 13, 14 et 15, correspondant au deuxième mode de réalisation illustré sur la figure 6, présentent la variation de la résistance de Hall avec le champ magnétique appliqué perpendiculairement au plan des couches, pour différentes natures de l'oxyde utilisé et après différentes températures de recuit. La figure 13 correspond à une couche d'aluminium de 0,6 nanomètre subséquemment mise en présence d'une atmosphère d'oxygène. La figure 14 correspond à une couche d'aluminium de 1,6 nanomètre oxydée par un procédé plasma, la figure 15 correspond à une couche de magnésium de 1,4 nanomètre subséquemment mise en présence d'une atmosphère d'oxygène.

Dans ces trois cas, il est possible, par un traitement thermique adéquat, de stabiliser l'aimantation de la couche de cobalt dans une direction perpendiculaire au plan des couches en l'absence de champ magnétique appliqué.

Si alors, pour les deuxième, cinquième ou sixième formes de réalisation, on dépose, avant la couche O des empilements schématisés sur les figures 6, 10 ou 11, une première couche magnétique à aimantation également perpendiculaire au plan, on réalisera ainsi une structure du type jonction tunnel magnétique à aimantations perpendiculaires au plan des couches.

Il est donc tout à fait possible, par traitement thermique, de modifier à volonté les propriétés magnétiques de ce type de matériau, afin de maximiser la résistance de Hall et/ou d'ajuster en fonction de l'application visée la stabilité de l'aimantation par rapport au champ magnétique extérieur (en particulier son champ coercitif). Ces traitements thermiques ont de plus l'avantage de rendre l'élément magnétique beaucoup plus stable en terme structural par rapport à d'éventuelles variations ultérieures de température.

Il faut à nouveau rappeler que ce paramètre (le champ coercitif, ainsi que défini en relation avec la figure 2) peut lui aussi être ajusté, non seulement en modifiant la température des traitement thermiques post-dépôt comme illustré sur les figures 13, 14 et 15, mais aussi, soit en modifiant la composition de l'empilement (épaisseurs de couches, nature du matériau ferromagnétique, présence ou non d'une deuxième couche O'), soit en modifiant les conditions de dépôt (vitesse, température, champ magnétique), soit en utilisant une technique ou des conditions d'oxydation différentes (pression d'oxygène, temps d'oxydation, puissance plasma, etc.).

L'invention concerne également le procédé de fabrication d'éléments magnétiques conformes aux descriptions précédentes. Ce procédé est défini comme suit, sans que cette présentation ne soit en aucun cas exhaustive.

Les différentes couches des empilements présentés ici sont déposées par pulvérisation cathodique avec des vitesses de dépôt de l'ordre de 0,1 nm/s, sur des substrats de silicium recouverts de 500 nanomètres de silicium oxydé thermiquement.

Les couches d'oxyde, d'hydrure ou de nitrure sont réalisées en déposant tout d'abord la couche du matériau correspondant, puis en effectuant une oxydation, hydruration ou nitruration plasma de cette couche avec des puissances de l'ordre de 10 W sous une pression de $3 \times 10^{-3}$ mbar d'oxygène, d'hydrogène ou d'azote pendant une durée de quelques secondes à quelques minutes.

Tout d'abord, on dépose une couche, d'aluminium par exemple, d'une épaisseur de l'ordre de 0,3 à 5 nanomètres. L'échantillon est ensuite soumis à un plasma, d'oxygène par exemple, dans des conditions de pression, puissance et temps bien définies. Ceci permet de transformer cet aluminium métallique en oxyde d'aluminium.

Il est évident que, cette couche d'alumine étant isolante électriquement, son épaisseur est beaucoup moins critique que celle des autres couches métalliques. Ceci est en revanche différent si l'oxyde (ou l'hydrure ou le nitrure) du métal considéré est conducteur électrique. Dans le cas d'une couche isolante, ce qui fixe son épaisseur dépend à la fois des propriétés de croissance de cette couche, dont la rugosité peut s'amplifier avec l'épaisseur et donc avoir un effet néfaste sur la qualité de croissance des couches suivantes, et des mécanismes d'oxydation qui peuvent éventuellement se modifier en fonction de l'épaisseur totale. Les exemples suivants concernent une épaisseur d'aluminium de 1,6 nanomètre, correspondant approximativement à 2 nanomètres d'alumine après oxydation de cette couche métallique.

Cette étape de dépôt de la première couche O peut éventuellement être omise, si c'est le substrat (à base d'oxyde ou de nitrure) lui-même qui constitue la première couche O.

On dépose ensuite une couche de cobalt, d'une épaisseur généralement faible. Dans les exemples décrits ci après, l'épaisseur de la couche de cobalt a été fixée à 1,5 nanomètre. Le choix d'une épaisseur relativement faible permet également de ne pas trop diminuer la résistivité de cette couche comparée à celle d'une couche plus épaisse.

Inversement, trop diminuer cette épaisseur pourrait, soit diminuer l'aimantation intrinsèque de cette couche, soit fortement diminuer sa température d'ordre magnétique. Dans les deux cas, ceci conduirait à une diminution de l'aimantation effective de cette couche à la température d'utilisation de l'élément magnétique, à savoir à proximité de la température ambiante. Selon la relation (1), ceci conduirait à une diminution de la résistivité de Hall, et donc à une diminution du signal de sortie du dispositif. Pour d'autres types d'applications décrites dans la présente invention, on pourra augmenter cette épaisseur de la couche magnétique jusqu'à 5 nanomètres.

Cette bicouche oxyde / métal magnétique, ou hydrure / métal magnétique, ou nitrure / métal magnétique, peut éventuellement être surmontée par une couche d'un métal non ferromagnétique ayant pour but, soit de protéger l'ensemble de la structure ainsi réalisée contre une oxydation naturelle ultérieure, soit de faciliter le passage d'un courant électrique, soit encore d'induire un couplage magnétique d'échange avec la couche magnétique.

Cette bicouche oxyde / métal magnétique, ou hydrure / métal magnétique, ou nitrure / métal magnétique, peut éventuellement être surmontée par une couche d'un oxyde, hydrure ou nitrure fabriqué suivant une des techniques citées plus haut permettant de protéger l'ensemble de la structure ainsi réalisée contre une oxydation naturelle ultérieure, sans pour autant abaisser la résistance électrique de l'empilement contrairement au cas ci-dessus évoqué.

Enfin, il est possible de réaliser des traitements thermiques ou des traitements magnétiques pendant ou après le dépôt de l'empilement.

Par traitements thermiques, on entend le fait de soumettre le matériau ainsi préparé à une température plus élevée que la température à laquelle il a été déposé, pendant un temps plus ou moins long, dans une atmosphère raréfiée ou en présence éventuelle d'un certain gaz ou mélange de différents gaz, tels que oxygène, hydrogène ou azote par exemple.

Par traitements magnétiques, on entend l'application d'un champ magnétique d'intensité et de direction judicieusement choisies, soit pendant une ou plusieurs des étapes de dépôt des différentes couches constitutives de l'empilement, soit pendant une des étapes de traitements thermiques décrites ci-dessus.

Ces traitements, thermiques et/ou magnétiques, ont pour but par exemple d'augmenter la résistivité longitudinale de l'empilement, par disruption éventuelle de la couche magnétique et/ou formation d'un alliage aux interfaces. Ils peuvent également avoir pour but de modifier la structure chimique ou cristallographique des couches, et en conséquence de modifier les propriétés magnétiques de l'empilement ainsi réalisé.

**Revendications**

1. Elément magnétique tricouches à champ démagnétisant effectif réduit ou à aimantation hors du plan, comportant, sur un substrat, une première couche d'oxyde, d'hydrure ou de nitrure O, surmontée d'une couche métallique magnétique M, elle-même surmontée soit d'une seconde couche d'oxyde, d'hydrure ou de nitrure O', soit d'une couche métallique non ferromagnétique M', *caractérisé* :

    • **en ce que** la couche M est continue et présente une épaisseur comprise entre 1 et 5 nanomètres,
    • et **en ce qu'**il existe, pour une gamme de température égale ou supérieure à la température ambiante, une anisotropie magnétique interfaciale perpendiculaire au plan des couches aux interfaces O/M et M/O', apte à diminuer le champ démagnétisant effectif de la couche M ou à orienter l'aimantation de la couche M sensiblement perpendiculairement au plan des couches.

2. Elément magnétique tricouches selon la revendication 1, *caractérisé* :

    • **en ce que** la couche métallique magnétique M est constituée d'un matériau magnétique, d'un alliage magnétique ou d'une multicouche formée de l'alternance de matériaux non magnétiques et magnétiques, ces derniers étant choisis dans le groupe constitué par Fe, Ni, Co ou leurs alliages,
    • et **en ce que** la ou les couches d'oxydes, d'hydrures ou de nitrures O et O' présentent une épaisseur au moins égale à 0,3 nanomètre et sont réalisées à base d'éléments choisis dans le groupe comprenant A1, Mg, Ru, Ta, Cr, Zr, Hf, Ti, V, Si, Cu, W, Co, Ni, Fe ou leurs alliages, et plus généralement de tout matériau ou alliage susceptible de former des oxydes, hydrures ou nitrures stables.

3. Elément magnétique tricouches selon l'une des revendications 1 et 2, *caractérisé* **en ce que** le substrat est en silicium recouvert de silicium oxydé ou nitruré, thermiquement ou naturellement, sur une épaisseur comprise entre 1 et 500 nanomètres.

4. Elément magnétique tricouches selon l'une des revendications 1 et 2, *caractérisé* **en ce que** le substrat est un matériau transparent, et notamment du verre ou de l'oxyde de magnésium.

5. Elément magnétique tricouches selon l'une des revendications 1 et 2, *caractérisé* **en ce que** le substrat joue le rôle de la première couche O.

6. Elément magnétique tricouches selon l'une des revendications 1 à 5, *caractérisé* **en ce que** la couche M contient des additions de métaux non magnétiques Pd ou Pt, ou d'éléments choisis dans le groupe comprenant Si, C, B, P.

7. Elément magnétique tricouches selon l'une des revendications 1 et 2, *caractérisé* **en ce que** les couches O et O' sont réalisées à partir d'un même matériau non magnétique.

8. Elément magnétique tricouches selon l'une des revendications 1 et 2, *caractérisé* **en ce que** les couches O et O' présentent la même épaisseur.

9. Elément magnétique tricouches selon l'une des revendications 1 et 2, *caractérisé* **en ce que** les épaisseurs des couches O et O' sont différentes.

10. Elément magnétique tricouches selon l'une des revendications 5 à 9, *caractérisé* :

    • **en ce que** la couche métallique magnétique M présente une épaisseur comprise entre 1 et 5 nanomètres,
    • **en ce que** les couches O et O' présentent une épaisseur comprise entre 0,3 et 5 nanomètres.

11. Elément magnétique tricouches selon l'une quelconque des revendications 1 à 10, *caractérisé* **en ce que** les compositions chimiques des couches O et O' sont différentes.

12. Elément magnétique tricouches selon l'une quelconque des revendications 1 à 11, *caractérisé* **en ce que** l'une au moins des couches O ou O' est elle-même constituée d'une pluralité de couches réalisée en oxyde, en hydrure ou en nitrure.

13. Elément magnétique tricouches selon l'une quelconque des revendications 1 à 12, *caractérisé* **en ce que** la couche non ferromagnétique M' est réalisée en un matériau antiferromagnétique réputé pour induire un couplage d'anisotropie d'échange avec la couche magnétique M, par exemple FeMn, IrMn, PtMn, NiMn.

**14.** Elément magnétique tricouches selon la revendication 13, *caractérisé* **en ce qu'**une couche métallique non magnétique d'une épaisseur comprise entre 0,1 et 1 nanomètre est, insérée entre la couche M et la couche M' réputée pour induire un couplage d'anisotropie d'échange avec ladite couche M.

**15.** Elément magnétique tricouches selon l'une quelconque des revendications 1 à 14, *caractérisé* **en ce que** cet élément est lui-même déposé au-dessus d'une première couche magnétique présentant également soit un champ démagnétisant effectif réduit, soit une aimantation orientée sensiblement perpendiculairement au plan des couches.

**16.** Elément magnétique tricouches selon l'une quelconque des revendications 1 à 15, *caractérisé* **en ce que** ses dimensions latérales sont inférieures à 1 micromètre.

**17.** Procédé de réalisation d'un élément magnétique tricouches selon l'une quelconque des revendication 1 à 16, *caractérisé* **en ce qu'**il comprend les étapes suivantes :

• dépôt sur une surface électriquement isolante préalablement oxydée ou nitrurée d'une couche magnétique M ;
• dépôt d'une couche O par pulvérisation cathodique sur ladite couche M, puis soumission de cette couche O à une opération d'oxydation, nitruration ou hydruration, ou dépôt d'une couche non ferromagnétique M' sur ladite couche M.

**18.** Capteur de champ magnétique *caractérisé* **en ce qu'**il est constitué d'un élément magnétique tricouches selon l'une quelconque des revendications 1 à 16, présentant un champ d'anisotropie perpendiculaire contrebalançant presque son champ démagnétisant.

**19.** Mémoire magnétique *caractérisée* **en ce qu'**elle est constituée d'un élément magnétique tricouches selon l'une quelconque des revendications 1 à 16, dans lequel l'aimantation de la couche magnétique est orientée perpendiculairement au plan des couches en l'absence de champ magnétique extérieur.

**20.** Mémoire magnétique *caractérisée* **en ce qu'**elle est constituée d'un élément magnétique tricouches selon l'une quelconque des revendications 1 à 16, dans lequel l'aimantation de la couche magnétique est orientée perpendiculairement au plan des couches sous forme de domaines magnétiques pointant alternativement vers le bas et vers le haut.

**21.** Porte logique magnétique *caractérisée* **en ce qu'**elle est constituée d'un élément magnétique tricouches selon l'une quelconque des revendications 1 à 16, dans lequel l'aimantation de la couche magnétique est orientée perpendiculairement au plan des couches en l'absence de champ magnétique extérieur.

**22.** Procédé pour la mise en oeuvre d'un capteur de champ magnétique, d'une mémoire magnétique ou d'une porte logique magnétique selon l'une des revendications 18 à 21, *caractérisé* **en ce que** l'orientation de l'aimantation de la couche magnétique de l'élément magnétique est détectée par mesure de l'Effet Hall Extraordinaire par circulation d'un courant électrique dans une direction parallèle au plan des couches.

**23.** Procédé pour la mise en oeuvre d'un capteur de champ magnétique, d'une mémoire magnétique ou d'une porte logique magnétique selon l'une des revendications 18 à 21, *caractérisé* **en ce que** l'orientation de l'aimantation de la couche magnétique de l'élément magnétique est détectée par mesure de l'Effet Kerr ou de l'Effet Faraday magnéto-optiques.

**24.** Procédé pour la mise en oeuvre d'un capteur de champ magnétique, d'une mémoire magnétique ou d'une porte logique magnétique selon l'une des revendications 18 à 21, *caractérisé* **en ce que** l'orientation de l'aimantation de la couche magnétique de l'élément magnétique est détectée par mesure de la magnétorésistance par circulation d'un courant électrique dans une direction sensiblement perpendiculaire au plan des couches.

**25.** Procédé pour la mise en oeuvre d'une mémoire magnétique ou d'une porte logique magnétique selon l'une des revendications 18 à 21, *caractérisé* **en ce que** l'orientation de l'aimantation de la couche magnétique de l'élément magnétique est détectée par mesure de la magnétorésistance d'un capteur magnétorésistif situé à proximité de l'élément magnétique.

**Claims**

1. A three-layer magnetic element with a reduced effective demagnetising field or out-of-plane magnetisation comprising, on a substrate, a first oxide, hydride or nitride layer O having a metal magnetic layer M mounted thereon, the latter having either a second oxide, hydride or nitride layer O', or a non-ferromagnetic metal layer M' mounted thereon, *characterised*:

   • **in that** layer M is continuous and has a thickness of 1 to 5 nanometers,
   • and **in that** there is, for a range of temperature equal to or greater than ambient temperature, interfacial magnetic anisotropy perpendicular to the layer plane on interfaces O/M and M/O' that is capable of decreasing the effective demagnetising field of layer M or orienting the magnetisation of layer M in a manner substantially perpendicular to the layer plane.

2. The three-layer magnetic element as claimed in claim 1, *characterised*:

   • **in that** the magnetic metal layer M consists of a magnetic material, a magnetic alloy or a multilayer formed by an alternating sequence of non-magnetic and magnetic materials, the latter being selected from the group comprising Fe, Ni, Co or alloys thereof,
   • and **in that** the oxide, hydride or nitride layer(s) O and O' has/have a thickness of at least 0.3 nanometer and is/are based on elements selected from the group comprising Al, Mg, Ru, Ta, Cr, Zr, Hf, Ti, V, Si, Cu, W, Co, Ni, Fe or alloys thereof and, more generally, any material or alloy capable of forming stable oxides, hydrides or nitrides.

3. The three-layer magnetic element as claimed in claim 1 or 2, *characterised* **in that** the substrate is made of silicon covered in thermally or naturally oxidized or nitrided silicon to a depth of 1 to 500 nanometers.

4. The three-layer magnetic element as claimed in claim 1 or 2, *characterised* **in that** the substrate is made of a transparent material, especially glass or magnesium oxide.

5. The three-layer magnetic element as claimed in claim 1 or 2, *characterised* **in that** the substrate acts as first layer O.

6. The three-layer magnetic element as claimed in any of claims 1 to 5, *characterised* **in that** layer M contains added non-magnetic metals Pd or Pt or elements selected from the group comprising Si, C, B, P.

7. The three-layer magnetic element as claimed in claim 1 or 2, *characterised* **in that** layers O and O' are made of the same non-magnetic material.

8. The three-layer magnetic element as claimed in claim 1 or 2, *characterised* **in that** layers O and O' have the same thickness.

9. The three-layer magnetic element as claimed in claim 1 or 2, *characterised* **in that** the thicknesses of layers O and O' are different.

10. The three-layer magnetic element as claimed in any of claims 5 to 9, *characterised*:

    • **in that** the metal magnetic layer M has a thickness of 1 to 5 nanometers,
    • **in that** layers O and O' have a thickness of 0.3 to 5 nanometers.

11. The three-layer magnetic element as claimed in any of claims 1 to 10, *characterised* **in that** the chemical compositions of layers O and O' are different.

12. The three-layer magnetic element as claimed in any of claims 1 to 11, *characterised* **in that** at least one of layers O and O' itself consists of a plurality of layers made of oxide, hydride or nitride.

13. The three-layer magnetic element as claimed in any of claims 1 to 12, *characterised* **in that** the non-ferromagnetic layer M' is made of an antiferromagnetic material known to induce exchange anisotropy coupling with magnetic layer M, for example FeMn, IrMn, PtMn, NiMn.

14. The three-layer magnetic element as claimed in claim 13, *characterised* **in that** a non-magnetic metal layer having a thickness of 0.1 to 1 nanometer is inserted between layer M and layer M' which is known to induce exchange anisotropy coupling with said layer M.

15. The three-layer magnetic element as claimed in any of claims 1 to 14, *characterised* **in that** said element is itself deposited on top of a first magnetic layer that also has either a reduced effective demagnetising field or magnetisation oriented substantially perpendicular to the layer plane.

16. The three-layer magnetic element as claimed in any of claims 1 to 15, *characterised* **in that** its lateral dimensions are less than 1 micrometer.

17. A method for producing a three-layer magnetic element according to any one of claims 1 to 16, *characterised* **in that** it involves the following steps:

   • depositing, on an electrically insulating surface that has previously been oxidised or nitrided, a magnetic layer M;
   • depositing a layer O by cathode sputtering on said layer M and then subjecting this layer O to an oxidation, nitriding or hydriding operation or depositing non-ferromagnetic layer M' on said layer M.

18. A magnetic field sensor *characterised* **in that** it consists of a three-layer magnetic element as claimed in any of claims 1 to 16 having a perpendicular anisotropy field that almost counterbalances its demagnetising field.

19. A magnetic memory *characterised* **in that** it consists of a three-layer magnetic element as claimed in any of claims 1 to 16 in which magnetisation of the magnetic layer is perpendicular to the layer plane in the absence of any external magnetic field.

20. A magnetic memory *characterised* **in that** it consists of a three-layer magnetic element as claimed in any of claims 1 to 16 in which magnetisation of the magnetic layer is perpendicular to the layer plane in the form of magnetic domains that point alternately downwards and upwards.

21. A magnetic logic gate *characterised* **in that** it consists of a three-layer magnetic element as claimed in any of claims 1 to 16 in which magnetisation of the magnetic layer is perpendicular to the layer plane in the absence of any external magnetic field.

22. A method for using a magnetic field sensor, a magnetic memory or a magnetic logic gate as claimed in any of claims 18 to 21, *characterised* **in that** the orientation of the magnetisation of the magnetic layer of the magnetic element is detected by measuring the extraordinary Hall effect by injecting an electric current in a direction parallel to the layer plane.

23. A method for using a magnetic field sensor, a magnetic memory or a magnetic logic gate as claimed in any of claims 18 to 21, *characterised* **in that** the orientation of the magnetisation of the magnetic layer of the magnetic element is detected by measuring the Kerr effect or the Faraday magneto-optical effect.

24. A method for using a magnetic field sensor, a magnetic memory or a magnetic logic gate as claimed in any of claims 18 to 21, *characterised* **in that** the orientation of the magnetisation of the magnetic layer of the magnetic element is detected by measuring the magnetoresistance by injecting an electric current in a direction that is substantially perpendicular to the layer plane.

25. A method for using a magnetic memory or a magnetic logic gate as claimed in any of claims 18 to 21, *characterised* **in that** the orientation of the magnetisation of the magnetic layer of the magnetic element is detected by measuring the magnetoresistance of a magnetoresistive sensor located close to the magnetic element.

**Patentansprüche**

1. Dreischichtiges magnetisches Element mit einem reduzierten effektiven Entmagnetisierungsfeld oder mit einer Magnetisierung außerhalb der Ebene, umfassend eine erste Oxid-, Hydrid- oder Nitridschicht O auf einem Substrat, auf welcher eine magnetische Metallschicht M aufgesetzt ist, auf welcher wiederum entweder eine zweite Oxid-, Hydrid oder Nitridschicht O' oder eine nicht ferromagnetische Metallschicht M' aufgesetzt ist, **dadurch gekenn-**

**zeichnet, dass**

- die Schicht M durchgehend ist und eine Dicke zwischen 1 und 5 Nanometer aufweist,
- es für einen Bereich von Temperaturen, die gleich oder größer sind als die Umgebungstemperatur, eine zu der Ebene der Schichten an den Schnittstellen O/M und M/O' senkrechte magnetische Grenzflächenanisotropie gibt, welche geeignet ist, das effektive Entmagnetisierungsfeld der Schicht M zu reduzieren oder die Magnetisierung der Schicht M weitestgehend senkrecht zu der Ebene der Schichten auszurichten.

2.  Dreischichtiges magnetisches Element nach Anspruch 1, **dadurch gekennzeichnet, dass**

- die magnetische Metallschicht M aus einem magnetischen Material, aus einer magnetischen Legierung oder aus einer Multischicht besteht, welche durch abwechselnde nicht magnetische und magnetische Materialien gebildet ist, wobei diese aus der Gruppe Fe, Ni, Co bzw. deren Legierungen gewählt sind,
- die Oxid-, Hydrid- bzw. Nitridschicht(en) O bzw. O'eine Dicke aufweisen, die mindestens 0,3 Nanometer beträgt, und aus Elementen aus der Gruppe Al, Mg, Ru, Ta, Cr, Zr, Hf, Ti, V, Si, Cu, W, Co, Ni, Fe bzw. deren Legierungen und im Allgemeinen aus jedem Material bzw. jeder Legierung hergestellt sind, die stabile Oxide, Hydride bzw. Nitride bilden können.

3.  Dreischichtiges magnetisches Element nach einem der Ansprüche 1 und 2, **dadurch gekennzeichnet, dass** das Substrat aus Silicium besteht, welches mit thermisch oder natürlich auf einer Dicke zwischen 1 und 500 Nanometer oxidiertem oder nitriertem Silicium überzogen ist.

4.  Dreischichtiges magnetisches Element nach einem der Ansprüche 1 und 2, **dadurch gekennzeichnet, dass** das Substrat ein durchsichtiges Material, insbesondere Glas oder Magnesiumoxid ist.

5.  Dreischichtiges magnetisches Element nach einem der Ansprüche 1 und 2, **dadurch gekennzeichnet, dass** das Substrat als erste Schicht O fungiert.

6.  Dreischichtiges magnetisches Element nach einem der Ansprüche 1 bis 5, **dadurch gekennzeichnet, dass** die Schicht M Beimengungen von nicht magnetischen Metallen Pd oder Pt oder von Elementen aus der Gruppe Si, C, B, P enthält.

7.  Dreischichtiges magnetisches Element nach einem der Ansprüche 1 und 2, **dadurch gekennzeichnet, dass** die Schichten O und O' aus ein und demselben nicht magnetischen Material hergestellt sind.

8.  Dreischichtiges magnetisches Element nach einem der Ansprüche 1 und 2, **dadurch gekennzeichnet, dass** die Schichten O und O' die gleiche Dicke aufweisen.

9.  Dreischichtiges magnetisches Element nach einem der Ansprüche 1 und 2, **dadurch gekennzeichnet, dass** die Dicke der Schichten O und O' unterschiedlich ist.

10. Dreischichtiges magnetisches Element nach einem der Ansprüche 5 bis 9, **dadurch gekennzeichnet, dass**

- die magnetische Metallschicht M eine Dicke zwischen 1 und 5 Nanometer aufweist,
- die Schichten O und O' eine Dicke zwischen 0,3 und 5 Nanometer aufweisen.

11. Dreischichtiges magnetisches Element nach einem beliebigen der Ansprüche 1 bis 10, **dadurch gekennzeichnet, dass** die chemische Zusammensetzung der Schichten O und O' unterschiedlich ist.

12. Dreischichtiges magnetisches Element nach einem beliebigen der Ansprüche 1 bis 11, **dadurch gekennzeichnet, dass** mindestens eine der Schichten O und O' selbst durch eine Vielzahl von Schichten gebildet ist, die aus Oxid, Hydrid oder Nitrid bestehen.

13. Dreischichtiges magnetisches Element nach einem beliebigen der Ansprüche 1 bis 12, **dadurch gekennzeichnet, dass** die nicht ferromagnetische Schicht M' aus einem antiferromagnetischen Material, das als Induktor einer anisotropen Austauschkopplung mit der magnetischen Schicht M gilt, beispielsweise FeMn, IrMn, PtMn, NiMn, hergestellt ist.

**14.** Dreischichtiges magnetisches Element nach Anspruch 13, **dadurch gekennzeichnet, dass** eine nicht magnetische Metallschicht mit einer Dicke zwischen 0,1 und 1 Nanometer zwischen der Schicht M und der Schicht M' eingesetzt ist, welche als Induktor einer anisotropen Austauschkopplung mit der Schicht M gilt.

**15.** Dreischichtiges magnetisches Element nach einem beliebigen der Ansprüche 1 bis 14, **dadurch gekennzeichnet, dass** dieses Element selbst über einer ersten magnetischen Schicht angeordnet ist, die ebenfalls entweder ein reduziertes effektives Entmagnetisierungsfeld oder eine weitestgehend senkrecht zu der Eben der Schichten ausgerichtete Magnetisierung aufweist.

**16.** Dreischichtiges magnetisches Element nach einem beliebigen der Ansprüche 1 bis 15, **dadurch gekennzeichnet, dass** seine seitlichen Abmessungen geringer als 1 Mikrometer sind.

**17.** Verfahren zur Herstellung eines dreischichtigen magnetischen Elements nach einem beliebigen der Ansprüche 1 bis 16, **dadurch gekennzeichnet, dass** es die folgenden Schritte umfasst:

- Aufbringen einer magnetischen Schicht M auf eine elektrisch isolierende, zuvor oxidierte oder nitrierte Oberfläche,
- Aufbringen einer Schicht O durch Kathodensputtering auf die Schicht M und anschließend Oxidierung, Nitrierung oder Hydrierung dieser Schicht O, oder Aufbringen einer nicht ferromagnetischen Schicht M' auf die Schicht M.

**18.** Magnetfeldsensor, **dadurch gekennzeichnet, dass** er durch ein dreischichtiges magnetisches Element nach einem beliebigen der Ansprüche 1 bis 16 gebildet ist, mit einem senkrechten Anisotropiefeld, das sein Entmagnetisierungsfeld nahezu ausgleicht.

**19.** Magnetischer Speicher, **dadurch gekennzeichnet, dass** er durch ein dreischichtiges magnetisches Element nach einem beliebigen der Ansprüche 1 bis 16 gebildet ist, bei dem die Magnetisierung der magnetischen Schicht bei nicht vorhandenem äußerem Magnetfeld senkrecht zu der Ebene der Schichten ausgerichtet ist.

**20.** Magnetischer Speicher, **dadurch gekennzeichnet, dass** er durch ein dreischichtiges magnetisches Element nach einem beliebigen der Ansprüche 1 bis 16 gebildet ist, bei dem die Magnetisierung der magnetischen Schicht senkrecht zu der Ebene der Schichten in Form von abwechselnd nach unten und nach oben zeigenden magnetischen Bereichen ausgerichtet ist.

**21.** Magnetisches Logikgatter, **dadurch gekennzeichnet, dass** es durch ein dreischichtiges magnetisches Element nach einem beliebigen der Ansprüche 1 bis 16 gebildet ist, bei dem die Magnetisierung der magnetischen Schicht bei nicht vorhandenem äußerem Magnetfeld senkrecht zu der Ebene der Schichten ausgerichtet ist.

**22.** Verfahren zur Implementierung eines Magnetfeldsensors, eines magnetischen Speichers bzw. eines magnetischen Logikgatters nach einem der Ansprüche 18 bis 21, **dadurch gekennzeichnet, dass** die Ausrichtung der Magnetisierung der magnetischen Schicht des magnetischen Elements durch Messung des außergewöhnlichen Hall-Effekts anhand des Durchflusses eines elektrischen Stroms in einer parallel zu der Ebene der Schichten verlaufenden Richtung erfasst wird.

**23.** Verfahren zur Implementierung eines Magnetfeldsensors, eines magnetischen Speichers bzw. eines magnetischen Logikgatters nach einem der Ansprüche 18 bis 21, **dadurch gekennzeichnet, dass** die Ausrichtung der Magnetisierung der magnetischen Schicht des magnetischen Elements durch Messung des magnetooptischen Kerr- oder Faraday-Effekts erfasst wird.

**24.** Verfahren zur Implementierung eines Magnetfeldsensors, eines magnetischen Speichers bzw. eines magnetischen Logikgatters nach einem der Ansprüche 18 bis 21, **dadurch gekennzeichnet, dass** die Ausrichtung der Magnetisierung der magnetischen Schicht des magnetischen Elements durch Messung des Magnetwiderstandes anhand des Durchflusses eines elektrischen Stroms in einer weitestgehend senkrecht zu der Ebene der Schichten verlaufenden Richtung erfasst wird.

**25.** Verfahren zur Implementierung eines magnetischen Speichers bzw. eines magnetischen Logikgatters nach einem der Ansprüche 18 bis 21, **dadurch gekennzeichnet, dass** die Ausrichtung der Magnetisierung der magnetischen Schicht des magnetischen Elements durch Messung des Magnetwiderstandes eines in der Nähe des magnetischen Elements angeordneten magnetoresistiven Sensors erfasst wird.

Résistivité de Hall

Champ Magnétique

**Figure 1**

$Pt_{1,8nm}/Co_{0,6nm}/Pt_{1,8nm}$

**Figure 2**

**Figure 3**

**Figure 4**

SiO$_2$/Co 1.5nm/Pt 3.0nm

Figure 5

Figure 6

SiO$_2$/AlOx 2.0nm/Co 1.5nm/Pt 3.0nm

Figure 7

Figure 8

| Oxyde |
| Cobalt |
| Oxyde |
| Substrat |

**Figure 9**

| Antiferromagnétique |
| Cobalt |
| Oxyde |
| Substrat |

**Figure 10**

**Figure 11**

**Figure 12**

SiO$_2$/AlOx 0.6nm/Co 1.5nm/Pt 3.0nm

**Figure 13**

SiO$_2$/AlOx 2.0nm/Co 1.5nm/Pt 3.0nm

**Figure 14**

Figure 15

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6920062 B

**Littérature non-brevet citée dans la description**

- **B. RODMACQ ; S. AUFFRET. ; B. DIENY ; S. MONSO ; P. BOYER.** Crossovers from in-plane to perpendicular anisotropy in magnetic tunnel junctions as a function of the barrier degree of oxidation. *Journal of Applied Physics,* 2003, vol. 93, 7513
- **CH. MORAWE ; H. ZABEL.** Structure and thermal stability of sputtered metal/oxide multilayers: the case of Co/Al2O. *Journal of Applied Physics,* 1995, vol. 77, 1969
- **B. DIENY ; S. SANKAR ; M. R. MCCARTNEY ; D. J. SMITH ; P. BAYLE-GUILLEMAUD ; A. E. BERKOWITZ.** Spin-dependent tunnelling in discontinuous metal/insulator multilayers. *Journal of Magnetism and Magnetic Materials,* 1998, vol. 185, 283

- **G. S. D. BEACH ; A. E. BERKOWITZ.** Co-Fe metallnative-oxide multilayers: a new direction in soft magnetic thin film design 1. Quasi-static properties and dynamic response. *IEEE Transactions on Magnetics,* 2005, vol. 41, 2043
- **G. S. D. BEACH ; A. E. BERKOWITZ.** Co-Fe metal/native-oxide multilayers: a new direction in soft magnetic thin film design II. Microscopic characteristics and interactions. *IEEE Transactions on Magnetics,* 2005, vol. 41, 2053
- **C. CHRISTIDES ; TH. SPELIOTIS.** Polarity of anomalous Hall effect hysteresis loops in (Pt/Co)15/AF/(Co/Pt)15 (AF= FeMn, NiO) multilayers with perpendicular anisotropy. *Journal of Applied Physics,* 2005, vol. 97, 013901